(19) Europäisches Patentamt / European Patent Office / Office européen des brevets

(11) EP 2 327 992 A1

(12) **DEMANDE DE BREVET EUROPEEN**

(43) Date de publication:
**01.06.2011 Bulletin 2011/22**

(51) Int Cl.:
*G01R 31/317* (2006.01)    *G01R 29/26* (2006.01)

(21) Numéro de dépôt: **10014405.4**

(22) Date de dépôt: **09.11.2010**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **24.11.2009  FR 0905630**

(71) Demandeur: **STMicroelectronics (Grenoble 2) SAS**
**38000 Grenoble (FR)**

(72) Inventeur: **Le-Gall, Hervé**
**38410 Sanit-Martin d'Uriage (FR)**

(74) Mandataire: **Marchand, André et al**
**OMNIPAT**
**24 Place des Martyrs de la Résistance**
**13100 Aix-en-Provence (FR)**

(54) **Procédé et dispositif d'analyse du comportement de l'alimentaion d'un circuit**

(57)  L'invention concerne un procédé de test d'un circuit intégré, comprenant la réalisation d'une série d'au moins trois tests, chacun comprenant des étapes de : sélection de deux noeuds parmi au moins trois noeuds de prélèvement d'un signal d'horloge, dans un circuit intégré (IC), prélèvement de deux signaux d'horloge (CK0, CK1, CK2) aux deux noeuds de prélèvement sélectionnés pendant une durée de test, détection et comptage d'événements apparaissant dans un signal de gigue entre les deux signaux d'horloge prélevés, pendant la durée de test, et détermination à partir de nombres d'événements comptés d'un résultat de test proportionnel à une somme de variances de gigue des deux signaux d'horloge prélevés, et à la fin de la série de tests, et détermination par un calcul matriciel de la variance de gigue de chacun des signaux d'horloge prélevés.

Fig. 1

EP 2 327 992 A1

**EP 2 327 992 A1**

**Description**

La présente invention concerne généralement la conception et le test de circuits intégrés. La présente invention s'applique en particulier aux systèmes sur puce SOC (System On Chip).

Les nouvelles technologies d'intégration tendent à offrir une plus grande densité de transistors, des interconnexions plus rapides. En intégrant sur une même puce des circuits hétérogènes pour réaliser ce que l'on appelle un "système sur puce", il est possible de réduire les coûts et les temps de conception et de fabrication de tels systèmes.

Ainsi, les systèmes SOC tendent de plus en plus à regrouper dans un même circuit intégré des composants matériels tels que des coeurs de processeur hétérogènes, des circuits spécialisés, et des mémoires, ainsi qu'une architecture de communication complexe appelée "réseau sur puce" NOC, reliant entre eux ces composants. En raison de la complexité grandissante des systèmes sur puce, il est souhaitable de mettre en oeuvre des outils de conception, de modélisation et de simulation permettant de tester un système à différentes étapes de conception, ceci afin de pouvoir valider le système à chacune de ces étapes. Il est également souhaitable de pouvoir tester un système ou un circuit intégré une fois qu'il est implanté totalement ou partiellement dans une puce. Or le test de circuits intégrés devient de plus en plus coûteux, représentant un part importante du coût total de fabrication du circuit. Pour réduire le coût de ces tests, des circuits supplémentaires, appelés circuits de test incorporés peuvent être prévus durant la conception du circuit intégré pour réaliser ces tests. Ces tests sont couramment appelés autotests intégrés BIST (Buit-in Self test).

Par ailleurs, les autotests intégrés tendent de plus en plus à permettre des analyses de performance du système. Durant une phase de mise au point, ces tests peuvent être appliqués à une partie isolée du système. Ces tests peuvent porter sur les sources de signaux d'horloge telles que des boucles à verrouillage de phase PLL (Phase-Lock Loop), les synthétiseurs de fréquence, les arbres de signaux d'horloge, les interconnexions entre les différentes parties du système, et également sur le bruit généré par des parties du système. L'analyse de l'intégrité de signaux peut être réalisée par une analyse fréquentielle, une analyse de paramètres S, une analyse de gigue, etc. L'intégrité des tensions d'alimentation d'un système est un point crucial pour les liaisons série à grande vitesse, et en particulier pour les interfaces de mémoires. Les tensions d'alimentation dans un circuit intégré peuvent être soumises à des parasites dont l'importance peut être liée à la longueur des liaisons fournissant ces tensions aux différentes parties du circuit intégré. Les tensions d'alimentation peuvent également être soumises à des variations résultant notamment de l'activité des différentes parties du circuit intégré.

Toutefois, l'analyse de l'intégrité des tensions d'alimentation, qui peut être réalisée dans le domaine fréquentiel, présente une grande complexité en raison de la faiblesse des oscillations apparaissant dans les tensions d'alimentation. D'une manière générale, il n'existe pas de métrique permettant de caractériser l'intégrité des tensions d'alimentation.

Il est pourtant souhaitable de pouvoir tester un circuit intégré afin d'obtenir des informations significatives et fiables sur l'intégrité de tensions d'alimentation du circuit intégré.

Des modes de réalisation concernent un procédé de test d'un circuit intégré, comprenant des étapes de réalisation d'une série d'au moins trois tests, chacun des tests comprenant des étapes consistant à : sélectionner deux noeuds parmi au moins trois noeuds de prélèvement d'un signal d'horloge, dans un circuit intégré, prélever deux signaux d'horloge aux deux noeuds de prélèvement sélectionnés pendant une durée de test, détecter et compter des événements apparaissant dans un signal de gigue entre les deux signaux d'horloge prélevés, pendant la durée de test, et déterminer à partir de nombres d'événements comptés un résultat de test proportionnel à une somme de variances de gigue des deux signaux d'horloge prélevés, le procédé comprenant une étape de détermination de la variance de gigue de chacun des signaux d'horloge prélevés durant la série de tests, le nombre de tests de la série de tests et les signaux prélevés à chacun des tests de la série de test étant choisis de manière à pouvoir déterminer par un calcul matriciel la variance de gigue de chacun des signaux d'horloge prélevés.

Selon un mode de réalisation, la variance de gigue d'un signal d'horloge prélevé en un noeud à distance d'une sortie d'un circuit de génération du signal d'horloge, est égale à une variance de gigue du signal d'horloge en sortie du circuit de génération du signal d'horloge prélevé, additionnée d'une variance de gigue introduite par une liaison transmettant le signal d'horloge entre la sortie du circuit de génération et le noeud de prélèvement du signal d'horloge, le procédé comprenant une étape de détermination de la variance de gigue du signal d'horloge en sortie du circuit de génération du signal d'horloge, et de la variance de gigue introduite par la liaison entre la sortie du circuit de génération du signal d'horloge et le noeud de prélèvement du signal d'horloge prélevé, le nombre de tests de la série de tests et les signaux prélevés à chacun des tests de la série de tests étant choisis de manière à pouvoir déterminer par un calcul matriciel la variance de gigue de chacun des signaux d'horloge en sortie de leur circuit de génération et la variance de gigue de chacune des liaisons entre un point de prélèvement sélectionné d'un signal d'horloge et la sortie du circuit de génération du signal d'horloge.

Selon un mode de réalisation, le procédé comprend une étape de prélèvement d'un échantillon d'un premier des deux signaux prélevés à chaque période d'un second des deux signaux prélevés, et de mémorisation des échantillons prélevés, les événements comptés comprenant des événements d'apparition d'un motif particulier ou de coïncidence avec un masque particulier, dans les échantillons mémorisés, et des événements de coïncidence de phase entre les

2

deux signaux prélevés.

Selon un mode de réalisation, le résultat de chacun des tests de la série de test est obtenu par la formule suivante:

$$R = \left(\frac{NA + NB}{NTc} \cdot |Tobs - Tref|\right)^2$$

dans laquelle R est le résultat du test, NA et NB sont les valeurs de deux compteurs d'apparition d'un motif particulier dans les échantillons mémorisés ou de coïncidence des échantillons mémorisés avec un masque particulier, NTc est la valeur d'un compteur incrémenté à chaque fois que les deux signaux prélevés sont détectés en phase, et Tobs et Tref sont les périodes des deux signaux prélevés.

Selon un mode de réalisation, le procédé comprend une étape de prévision dans le circuit intégré d'au moins un circuit d'analyse d'intégrité de tension d'alimentation comprenant un circuit de mesure de gigue et des multiplexeurs permettant de sélectionner des signaux d'horloge à prélever et des noeuds de prélèvement des signaux d'horloge.

Selon un mode de réalisation, le procédé comprend une étape de prévision dans le circuit intégré de plusieurs circuits d'analyse d'intégrité de tension d'alimentation comprenant chacun un circuit de mesure de gigue et des multiplexeurs permettant de sélectionner des signaux d'horloge à prélever et des noeuds de prélèvement des signaux d'horloge, les circuits d'analyse d'intégrité de tension d'alimentation étant localisés sur le circuit intégré entre des blocs du circuit intégré ou à proximité de sources de signaux d'horloge.

Selon un mode de réalisation, le procédé comprend des étapes de réalisation de la série de tests dans différentes conditions de fonctionnement du circuit intégré, de comparaison des variances de gigue obtenues à chaque série de test, et de déduction d'informations relatives à l'intégrité de tensions d'alimentation.

Des modes de réalisation concernent également un système test d'un circuit intégré, configuré pour mettre en oeuvre le procédé tel que défini précédemment.

Des modes de réalisation concernent également un circuit intégré comprenant au moins un circuit de génération d'un signal d'horloge, des noeuds de prélèvement de signal d'horloge, et un circuit d'analyse d'intégrité de tension d'alimentation configuré pour: recevoir d'un dispositif de test des signaux de sélection de deux noeuds de prélèvement de signaux d'horloge, parmi au moins trois noeuds de prélèvement, prélever deux signaux d'horloge aux deux noeuds de prélèvement sélectionnés pendant une durée de test, détecter et compter des événements apparaissant dans un signal de gigue entre les deux signaux d'horloge prélevés, pendant la durée de test, et fournir au dispositif de test les nombres d'événements comptés.

Selon un mode de réalisation, le circuit d'analyse d'intégrité de tension d'alimentation comprend un circuit de mesure de gigue et des multiplexeurs permettant de sélectionner des signaux d'horloge à prélever et des noeuds de prélèvement des signaux d'horloge.

Selon un mode de réalisation, le circuit intégré comprend plusieurs circuits d'analyse d'intégrité de tension d'alimentation comportant chacun un circuit de mesure de gigue et des multiplexeurs permettant de sélectionner des signaux d'horloge à prélever et des noeuds de prélèvement des signaux d'horloge, les circuits d'analyse d'intégrité de tension d'alimentation étant localisés sur le circuit intégré entre des blocs du circuit intégré ou à proximité de sources de signaux d'horloge.

Des modes de réalisation concernent également un dispositif de test comprenant une interface de connexion pour se connecter à un circuit intégré, et des moyens pour envoyer et recevoir des signaux par l'interface de connexion, le dispositif de test étant configuré pour réaliser une série d'au moins trois tests, chacun des tests comprenant des étapes consistant à : commander la sélection par le circuit intégré connecté à l'interface de connexion, de deux noeuds parmi au moins trois noeuds de prélèvement d'un signal d'horloge, le prélèvement par le circuit intégré de deux signaux d'horloge aux deux noeuds de prélèvement sélectionnés, pendant une durée de test, et la détection et le comptage d'événements apparaissant dans un signal de gigue entre les deux signaux d'horloge prélevés, pendant la durée de test, et acquérir et déterminer à partir des nombres d'événements comptés un résultat de test proportionnel à une somme de variances de gigue des deux signaux d'horloge prélevés, le dispositif de test étant configuré pour déterminer la variance de gigue de chacun des signaux d'horloge prélevés durant la série de tests, le nombre de tests de la série de tests et les signaux prélevés à chacun des tests de la série de test étant choisis de manière à pouvoir déterminer par un calcul matriciel la variance de gigue de chacun des signaux d'horloge prélevés.

Selon un mode de réalisation, la variance de gigue d'un signal d'horloge prélevé en un noeud à distance d'une sortie d'un circuit de génération du signal d'horloge, est égale à une variance de gigue du signal d'horloge en sortie du circuit de génération du signal d'horloge prélevé, additionnée d'une variance de gigue introduite par une liaison transmettant le signal d'horloge entre la sortie du circuit de génération et le noeud de prélèvement du signal d'horloge, le dispositif de test étant configuré pour déterminer la variance de gigue du signal d'horloge en sortie du circuit de génération du signal d'horloge, et la variance de gigue introduite par la liaison entre la sortie du circuit de génération du signal d'horloge et le noeud de prélèvement du signal d'horloge prélevé, le nombre de tests de la série de tests et les signaux prélevés à chacun des tests de la série de tests étant choisis de manière à pouvoir déterminer par un calcul matriciel la variance de gigue de chacun des signaux d'horloge en sortie de leur circuit de génération et la variance de gigue de chacune des liaisons entre un point de prélèvement sélectionné d'un signal d'horloge et la sortie du circuit de génération du signal d'horloge.

Selon un mode de réalisation, le dispositif de test est configuré calculer un résultat de chacun des tests de la série de test par la formule suivante:

$$R = \left(\frac{NA+NB}{NTc} \cdot |Tobs - Tref|\right)^2$$

dans laquelle R est le résultat du test, NA et NB sont les valeurs de deux compteurs d'apparition d'un motif particulier dans les échantillons mémorisés ou de coïncidence des échantillons mémorisés avec un masque particulier, NTc est la valeur d'un compteur incrémenté à chaque fois que les deux signaux prélevés sont détectés en phase, et Tobs et Tref sont les périodes des deux signaux prélevés.

Selon un mode de réalisation, le dispositif de test est configuré pour réaliser la série de tests dans différentes conditions de fonctionnement du circuit intégré, et comparer les variances de gigue obtenues à chaque série de tests.

Des exemples de réalisation de l'invention seront décrits dans ce qui suit, à titre non limitatif en relation avec les figures jointes parmi lesquelles :

- la figure 1 représente schématiquement un circuit d'analyse de l'intégrité de tensions d'alimentation dans un circuit intégré, selon un mode de réalisation,
- la figure 2 représente le circuit d'analyse représenté sur la figure 1, selon un mode de réalisation,
- la figure 3 représente schématiquement un circuit de mesure de gigue,
- la figure 4 représente une courbe de variation d'une quantité par rapport à une autre, et utilisée pour effectuer des tests d'intégrité de tensions d'alimentation.
- les figures 5 à 7 représentent schématiquement plusieurs circuits d'analyse de l'intégrité de tensions d'alimentation dans un circuit intégré, selon d'autres modes de réalisation,
- la figure 8 représente schématiquement un circuit intégré équipé de circuits d'analyse de l'intégrité de tensions d'alimentation, selon un mode de réalisation.

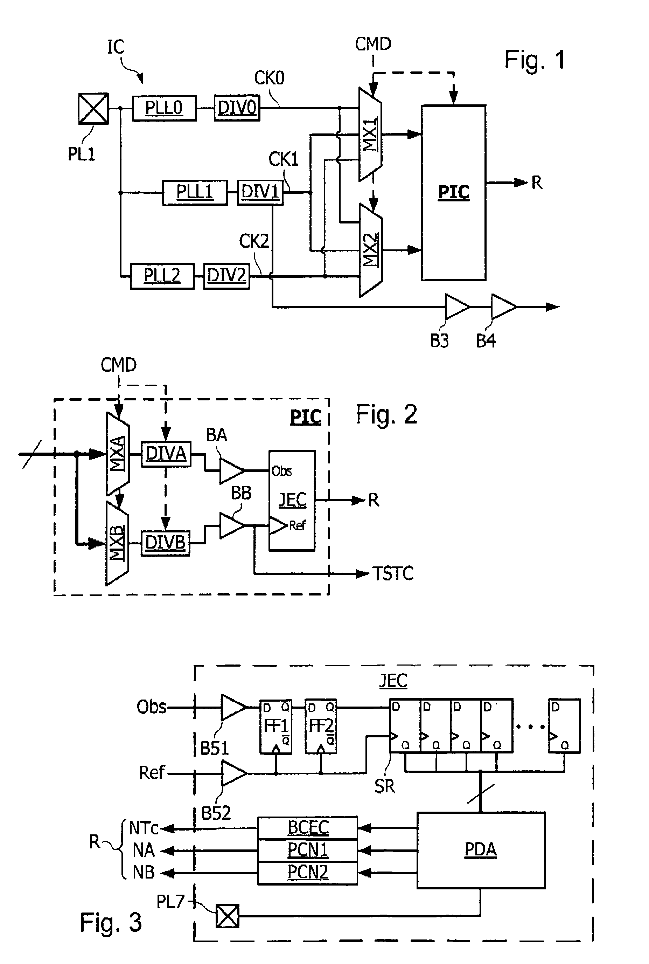

La figure 1 représente un circuit d'analyse de l'intégrité de tensions d'alimentation dans un circuit intégré IC, selon un mode de réalisation. Sur la figure 1, le circuit intégré IC comprend une plage de connexion PL1 connectée à des circuits de génération de signaux d'horloge PLL0, PLL1, PLL2. Une sortie de chacun des circuits PLL0, PLL1, PLL2 est connectée à un diviseur de fréquence respectif DIV0, DIV1, DIV2. Le circuit intégré IC comprend également deux multiplexeurs MX1, MX2 connectés chacun en entrée à une sortie de chacun des diviseurs DIV0, DIV1, DIV2. Une autre sortie du diviseur DIV1 est par exemple reliée à une autre partie du circuit intégré IC par l'intermédiaire de deux portes de transfert B3, B4. Les multiplexeurs MX1, MX2 comprennent chacun une sortie connectée à une entrée respective de signal d'horloge d'un circuit d'analyse d'intégrité de tensions d'alimentations PIC.

La figure 2 représente un exemple de réalisation du circuit d'analyse d'intégrité de tensions d'alimentations PIC. Sur la figure 2, le circuit PIC comprend un circuit de mesure de gigue (jitter) JEC et deux multiplexeurs MXA, MXB comprenant chacun plusieurs entrées, chaque entrée du multiplexeur MXA étant connectée avec une entrée du multiplexeur MXB à une entrée du circuit PIC. Les multiplexeurs MXA, MXB comprennent chacun une sortie reliée respectivement à une entrée de signal à mesurer Obs et à une entrée de signal d'horloge de référence Ref du circuit JEC par l'intermédiaire d'un diviseur de fréquence DIVA, DIVB et d'une porte de transfert BA, BB. Les portes de transfert BA et BB sont prévues dans le circuit pour compenser les temps de propagation des signaux dans les différentes liaisons du circuit.

Les multiplexeurs MX1, MX2, MXA, MXB sont commandés par un mot de commande CMD émis par un dispositif de test (non représenté) pour sélectionner deux des trois signaux d'horloge CK0, CK1, CK2 en sortie des diviseurs DIV0, DIV1, DIV3 à appliquer respectivement à l'entrée Ref et à l'entrée Obs du circuit JEC. Les diviseurs DIVA, DIVB sont également commandés par le mot de commande pour que les signaux appliqués fournis en entrée du circuit JEC aient la même fréquence. Le circuit JEC fournit une mesure R permettant de déduire une valeur proportionnelle à la somme des variances de gigue de chacun des signaux fournis en entrée du circuit de mesure.

La figure 3 représente un exemple de réalisation d'un circuit de mesure de gigue JEC entre deux signaux d'horloge. Sur la figure 3, le circuit JEC comprend deux bascules FF1, FF2. par exemple de type D, montées en cascade. La bascule FF1 reçoit sur une entrée D le signal à mesurer Obs, par l'intermédiaire d'une porte de transfert B51. Une sortie Q de la porte FF1 est connectée à une entrée D de la bascule FF2. Les bascules FF1 et FF2 reçoivent sur une entrée d'horloge, le signal de référence Ref, par l'intermédiaire d'une porte de transfert B52. La sortie Q de la porte FF2 est connectée à une entrée d'un registre à décalage SR1 recevant sur une entrée d'horloge le signal de référence Ref en sortie de la porte B52. La sortie du registre à décalage est connectée à un circuit de détection et d'analyse de motifs (pattern) PDA. Le registre à décalage SR1 comprend par exemple plusieurs bascules de type D montées en cascade dont les sorties Q sont connectées au circuit PDA. Le circuit PDA commande l'incrémentation et l'initialisation d'un ensemble de compteurs comprenant un compteur de front de battement FBCE, et deux compteurs de détection de motifs particuliers PCN1, PCN2. Le compteur de front de battement FBCE est incrémenté de un à chaque fois que le circuit PDA détecte que les deux signaux Ref et Obs sont en phase. Les deux bascules FF1, FF2 permettent de prélever un échantillon du signal Obs à chaque période du signal Ref, par exemple à chaque front montant du signal Ref. Les échantillons prélevés sont mémorisés dans le registre à décalage SR1, par exemple de 12 bits. Les compteurs PCN1, PCN2 sont incrémentés de un par le circuit PDA à chaque fois que le mot binaire dans le registre à décalage SR1 présente une valeur particulière ou coïncide avec un masque, mémorisé par le circuit PDA, c'est-à-dire lorsque certains des bits du mot binaire dans le registre SR1 présentent des valeurs particulières. Le circuit PDA est commandé et configuré par des signaux provenant d'une ou plusieurs plages de connexion PL7 connectées à un dispositif de test, tel que TSTT, permettant de transmettre au circuit PDA, notamment deux motifs ou masques de motifs à détecter. Les motifs ou masques fournis au circuit PDA sont par exemple choisis pour détecter des fronts montants et descendants dans le signal observé. A cet effet, les deux motifs ou masques fournis au circuit PDA peuvent être des mots binaires inverses l'un de l'autre.

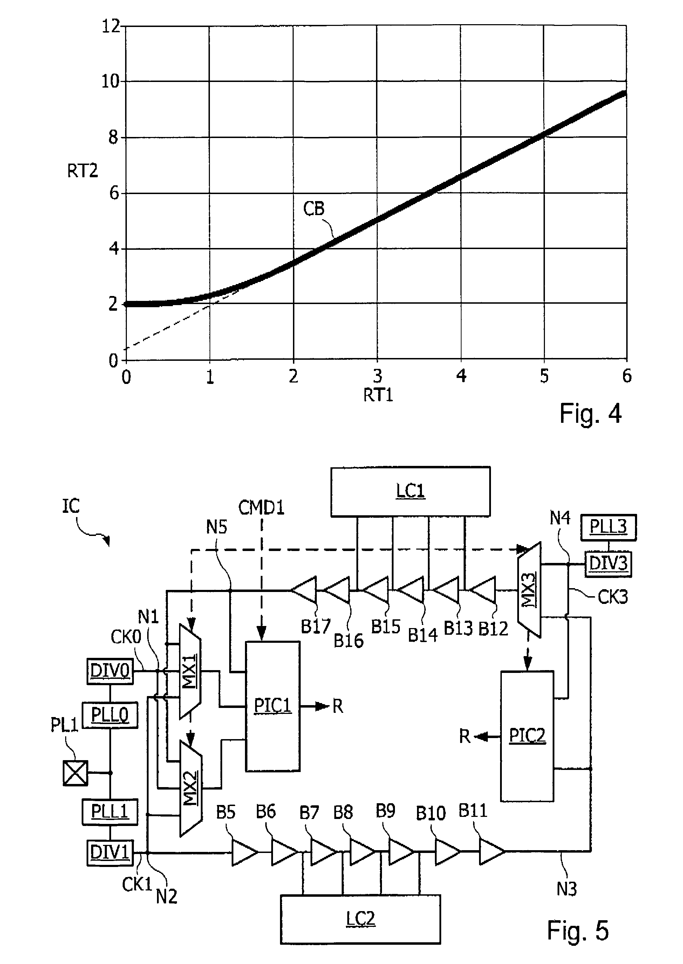

La figure 4 représente une courbe CB de variations de la quantité $RT2 = \dfrac{NA + NB}{NTc}$ par rapport à la quantité

$RT1 = \dfrac{SD}{\Delta T}$, NA et NB étant les valeurs des compteurs PCN1 et PCN2, NTc étant la valeur du compteur FBCE, SD étant l'écart type ou la racine carrée de la variance de la convolution des gigues du signal observé et du signal de référence, (résultats R1 à R19 dans les tableaux 1 à 3), et $\Delta T$ l'écart en valeur absolue entre les périodes respectives Tobs et Tref du signal observé Obs et du signal de référence Ref en entrée du circuit PIC, et qui sont connues. Les modes de réalisation décrits se basent sur l'hypothèse que les gigues observées sont des gigues gaussiennes et donc que la variance (ou l'écart type SD élevé au carré) de la convolution des gigues de deux signaux est l'addition des variances de gigue de ces deux signaux.

Il peut être remarqué sur la figure 4 que jusqu'à une valeur de RT1 voisine de 1, la quantité RT2 reste constante et voisine de la valeur 2 correspondant à une absence de gigue, et lorsque la quantité RT2 est supérieure à 2, la quantité RT1 augmente linéairement en fonction de la quantité RT2. Si l'on prolonge vers l'origine du repère de coordonnées, la droite formée par la courbe CB lorsque la quantité RT1 est supérieure à 2 (droite en trait interrompu), il peut être constaté que cette droite prolongée passe au voisinage de l'origine du repère de coordonnées (RT1 voisin de 0 lorsque RT2 est égal à 0). Il en résulte que lorsque RT2 est supérieur à 2, l'écart type de gigue SD est sensiblement proportionnel à la quantité RT2 multipliée par l'écart |Tobs - Tref|. Ainsi, les résultats de test R (résultats R1 à R19 des tableaux 1 à 3) peuvent être calculés de la manière suivante :

$$R = \left( \dfrac{NA + NB}{NTc} \cdot |Tobs - Tref| \right)^2 \qquad (1)$$

Un calculateur de test connecté à la sortie du circuit JEC peut alors être configuré pour réaliser une série de test comportant chacun des étapes de sélection des signaux fournis à un circuit PC10-PC16, d'attente d'une certaine durée de test, d'acquisition des valeurs NA, NB, NTc des compteurs PCN1, PCN2 et FBCE du circuit de mesure JEC, de détermination du résultat de test R à partir des valeurs obtenues, de la courbe CB et de la formule (1), et de déduction par des opérations de calcul matriciel des variances de gigue respectives des signaux d'horloge en sortie de circuits de génération de signal d'horloge, et de liaisons éventuelles par lesquelles ces signaux d'horloge ont transité dans le circuit intégré IC.

Les générateurs de signaux d'horloge ont une variance de gigue intrinsèque connue, liée à la technique de génération du signal d'horloge mise en oeuvre. L'écart entre la variance de gigue d'un signal d'horloge, obtenue par les tests décrits précédemment, et la variance de gigue intrinsèque du circuit de génération du signal d'horloge, fournit donc une variance de gigue liée à des variations de la tension d'alimentation alimentant le générateur de signal d'horloge. Ainsi, en procédant à des mesures de variance de gigue sur des signaux d'horloge à différents niveaux d'activité du circuit intégré, il peut être évalué la capacité des circuits d'alimentation du circuit intégré, à fournir des tensions d'alimentation constantes, et l'incidence de variations de ces tensions d'alimentation sur les signaux d'horloge. Par ailleurs, les variances de gigue de liaison obtenues permettent de localiser des sources de parasites dans un circuit intégré, et de localiser des liaisons trop longues.

Dans un mode de réalisation, le circuit d'analyse PIC est commandé par des mots de commande CMD émis par un dispositif de test (non représenté) pour réaliser une série de tests du circuit IC (figure 1), faisant intervenir tous les signaux d'horloge à analyser, et dont le nombre de tests est au moins égal au nombre de ces signaux. Un exemple d'une telle série de test est résumé dans le tableau 1 suivant :

Tableau 1

| Test | Ref | Obs | Résultat |
|------|-----|-----|----------|
| 1 | CK1 | CK0 | R1=V(Ck0)+V(Ck1) |
| 2 | CK2 | CK0 | R2=V(Ck0)+V(Ck2) |
| 3 | CK2 | CK1 | R3=V(Ck1)+V(Ck2) |

La colonne "Test" du tableau 1 indique un numéro pour chacun des tests de la série de tests. Les colonnes "Ref" et "Obs" indiquent les signaux d'horloge fournis respectivement aux entrées Ref et Obs du circuit JEC à chaque test de la série, et la colonne "Résultat" indique les valeurs de variance de gigue déduites des mesures fournies par le circuit JEC à chaque test. Dans un premier test, les signaux d'horloge CK0 et CK1 en sortie des diviseurs DIV0 et DIV1 sont fournis par les multiplexeurs MX1, MX2, MXA, MXB respectivement aux entrées Obs et Ref du circuit JEC. Le résultat obtenu R1 est proportionnel à la somme des variances de gigue V(CK0) et V(CK1) des signaux d'horloge CK0, CK1. De même, dans un second test, les signaux d'horloge CK0 et CK2 en sortie des diviseurs DIV0 et DIV2 sont fournis par les multiplexeurs MX1, MX2, MXA, MXB aux entrées Obs et Ref du circuit JEC. Le résultat obtenu R2 est proportionnel à la somme des variances de gigue V(CK0) et V(CK2) des signaux d'horloge CK0 CK2. Dans un troisième test, les signaux d'horloge CK1 et CK2 en sortie des diviseurs DIV1 et DIV2 sont fournis par les multiplexeurs MX1, MX2, MXA, MXB aux entrées Obs et Ref du circuit JEC. Le résultat obtenu R3 est proportionnel à la somme des variances de gigue V(CK1) et V(CK2) des signaux d'horloge CK1, CK2.

La série de trois tests mentionnés dans le tableau 1 permet donc d'obtenir un système de trois équations à trois inconnues CK0, CK1, CK2. Par un calcul matriciel classique, la variance de gigue V(CK0), V(CK1), V(CK2) de chacun des signaux d'horloge CK1, CK2, CK3 peut être déterminée d'une manière indépendante des variances de gigue des autres signaux d'horloge, comme suit :

$$V(CK0) = (R1 + R2 - R3)/2 \qquad (2)$$

$$V(CK1) = (R1 + R3 - R2)/2 \qquad (3)$$

$$V(CK1) = (R2 + R3 - R1)/2 \qquad (4)$$

La figure 5 représente une partie du circuit intégré IC comprenant la plage de connexion PL1 connectée aux circuits de génération de signaux d'horloge PLL0 et PLL1, les diviseurs de fréquence DIV0, DIV1 connectés en sortie des circuits PLL0, PLL1, les multiplexeurs MX1, MX2, et un autre circuit de génération de signal d'horloge PLL3 connecté à un diviseur de fréquence DIV3. Des entrées de chacun des multiplexeurs MX1, MX2 sont connectées respectivement à un noeud N1 en sortie du diviseur DIV0 et à un noeud N2 en sortie du diviseur DIV1. Le circuit intégré IC comprend également un multiplexeur MX3 comportant une entrée connectée à un noeud N4 à une sortie du diviseur DIV3, et une entrée connectée à un noeud N3 relié au noeud N2, par l'intermédiaire de portes de transfert B5, B6, B7, B8, B9, B10 et B11. La sortie du multiplexeur MX3 est reliée à un noeud N5 par l'intermédiaire de portes de transfert B12, B13, B14, B15, B16 et 817, le noeud N5 étant connecté à une entrée des multiplexeurs MX1 et MX2.

Selon un mode de réalisation, le circuit intégré IC comprend également deux circuits d'analyse de l'intégrité de tensions d'alimentation PIC1, PIC2 qui peuvent être identiques au circuit PIC représenté sur la figure 2. Le noeud N5 est relié à une entrée de signal d'horloge du circuit PIC1. Une entrée de signal d'horloge du circuit PIC2 est connectée au noeud N4 en sortie du diviseur DIV3. Une autre entrée de signal d'horloge du circuit PIC2 est connectée au noeud N3. Les portes de transfert B5 à B17 sont prévues dans le circuit pour compenser des temps de propagation des signaux dans les différentes liaisons du circuit et redresser les fronts dans les signaux d'horloge. Les portes B6 à B9 permettent également de générer un arbre de signaux d'horloge (clock tree) pour un circuit logique LC2 du circuit intégré IC. De même, les portes B12 à B15 permettent de générer un arbre de signaux d'horloge pour un autre circuit logique LC1 du circuit intégré IC.

Le circuit PIC2 peut ainsi recevoir le signal CK3 et le signal transitant par le noeud N3 et correspondant au signal CK1 transmis par les portes B5 à B12. Le circuit PIC1 peut recevoir les signaux d'horloge CK0 et CK1, ainsi que le signal circulant au noeud N5 et correspondant soit au signal CK3, soit au signal CK1 ayant transité par les noeuds N2 et N3.

Les multiplexeurs MX1 à MX3, MXA et MXB sont commandés par un mot de commande CMD1 émis par un dispositif de test (non représenté) pour sélectionner des noeuds de prélèvement N1 à N5 des signaux d'horloge CK0, CK1, CK3, à relier respectivement à l'entrée Ref et à l'entrée Obs des circuits PIC1 et PIC2.

Dans un mode de réalisation, les circuits PIC1, PIC2 sont commandés pour réaliser une série de tests telle que celle résumée dans le tableau 2 suivant:

Tableau 2

| Test | Circuit d'analyse | Ref | Obs | Liaison | Résultat |
|---|---|---|---|---|---|
| 1 | PIC1 | CK1 | CK0 | | R4=V(Ck0)+V(Ck1) |
| 2 | PIC1 | CK3 | CK0 | N4-N5/ | R5=V(Ck0)+V(Ck3)+V(N5) |
| 3 | PIC1 | CK3 | CK1 | N4-N5/ | R6=V(Ck1)+V(Ck3)+V(N5) |
| 4 | PIC2 | CK1 | CK3 | N2-N3/ | R7=V(Ck1)+V(Ck3)+V(N3) |
| 5 | PIC1 | CK1 | CK0 | N2-N3-N4-N5/ | R8=V(Ck0)+V(Ck1)+V(N3)+V(N5) |

La colonne "Test" du tableau 2 indique un numéro de chacun des tests de la série de tests. La colonne "Circuit d'analyse" indique le circuit d'analyse PIC1, PIC2 mis en oeuvre pour réaliser chacun des tests. Les colonnes "Ref" et "Obs" indiquent les signaux d'horloge fournis respectivement aux entrées Ref et Obs du circuit JEC du circuit d'analyse PIC1, PIC2 indiqué dans la colonne "Circuit d'analyse", à chacun des tests. La colonne "Liaison" indique le cas échéant par quelles liaisons ont transités les signaux mentionnés dans les colonnes Ref et Obs, et la colonne "Résultat" indique la valeur obtenue à partir de la mesure fournie par le circuit PIC1 ou PIC2 indiqué dans la colonne "Circuit d'analyse".

Dans un premier test, les signaux d'horloge CK0 et CK1 aux noeuds N1 et N2 sont fournis directement aux entrées Obs et Ref du circuit PIC1, par les multiplexeurs MX1 et MX2, et les multiplexeurs MXA, MXB du circuit PIC1. Le résultat obtenu R4 est proportionnel à la somme des variances de gigue V(CK0) et V(CK1) des signaux d'horloge CK0, CK1. Dans un second test, les multiplexeurs MX1 à MX3, et les multiplexeurs MXA, MXB du circuit PIC1 sont commandés pour fournir aux entrées Obs et Ref du circuit JEC du circuit PIC1, le signal d'horloge CK0 au noeud N1 et le signal d'horloge CK3 au noeud N5. Le signal au noeud N5 correspond donc au signal CK3 après avoir été transmis par la liaison entre les noeuds N4 et N5. Il est alors considéré que la variance de gigue du signal au noeud N5, obtenue à partir de la mesure fournie par le circuit PIC1 est sensiblement égale à la somme de la variance de gigue V(CK3) du signal CK3 au noeud N4 en sortie du diviseur DIV3, et de la variance de la gigue introduite par la liaison entre les noeuds N4 et N5, notée V(N5). Le résultat obtenu R5 est ainsi proportionnel à la somme des variances de gigue V(CK0), V(CK3) et V(N5) des signaux d'horloge CK0 et CK3 et de la liaison entre les noeuds N4 et N5. Dans un troisième test, les multiplexeurs MX1 à MX3, et les multiplexeurs MXA, MXB du circuit PIC1sont commandés pour fournir le signal d'horloge CK1 au noeud N2 et le signal CK3 au noeud N5, aux entrées Obs et Ref du circuit JEC du circuit PIC1. Le résultat obtenu R6 est donc proportionnel à la somme des variances de gigue V(CK1), V(CK3) et V(N5). Dans un quatrième test, les multiplexeurs MXA et MXB du circuit PIC2 sont commandés pour fournir le signal CK1 au noeud N3 et le signal d'horloge CK3 au noeud N4, aux entrées Obs et Ref du circuit JEC du circuit PIC2. Dans ce test, il est considéré que la variance de gigue du signal au noeud N3 est sensiblement égale à la somme de la variance de gigue V(CK1) du signal CK1 et de la variance de la gigue introduite par la liaison entre les noeuds N2 et N3, notée V(N3). Le résultat obtenu R7 est donc sensiblement proportionnel à la somme des variances de gigue V(CK1), V(N3) et V(CK3). Enfin, dans un cinquième test, les multiplexeurs MX1 à MX3 et les multiplexeurs MXA, MXB du circuit PIC1 sont commandés pour fournir aux entrées Obs et Ref du circuit JEC du circuit PIC1, le signal d'horloge CK0 en sortie du diviseur DIV0 et le signal CK1 au noeud N5 et ayant transité par les noeuds N2 et N3. La variance de gigue du signal au noeud N5 est donc égale à la somme de la variance de gigue V(CK1) du signal CK1, de la variance de la gigue V(N3) introduite par la liaison entre les noeuds N2 et N3, et de la variance de la gigue introduite par la liaison entre les noeuds N3 et N5 qui est sensiblement égale, en première approximation, à la variance de gigue de la liaison entre les noeuds N4 et N5, soit V(N5). Le résultat obtenu R8 est donc proportionnel à la somme des variances de gigue V(CK0), V(CK1), V(N3) et V(N5).

La série de cinq tests mentionnés dans le tableau 2 permet d'obtenir un système de cinq équations à cinq inconnues V(CK0), V(CK1), V(CK3), V(N3), V(N5). La résolution de ce système d'équations permet d'obtenir d'une manière indépendante, les variances de gigue respectives des signaux CK0, CK1, CK3 et celles introduites par la liaison entre les noeuds N2 et N3, et par la liaison entre le noeud N3 ou N4 et le noeud N5, comme suit:

$$V(CK0) = (R4 + R5 - R6)/2 \qquad (5)$$

$$V(CK1) = (R4 + R6 - R5)/2 \qquad (6)$$

$$V(CK3) = (R5 + R7 - R8)/2 \qquad (7)$$

$$V(N3) = (R7 + R8 - R4 - R6)/2 \qquad (8)$$

$$V(N5) = (R6 + R8 - R4 - R7)/2 \qquad (9)$$

Il est à noter que d'autres mesures de variance de gigue, c'est-à-dire d'autres combinaisons de signaux fournis en entrée de l'un ou l'autre des circuits PIC1, PIC2, peuvent être envisagées pour aboutir à un résultat voisin ou identique. Il importe simplement que le choix des signaux fournis aux entrées des circuits PIC1, PIC2 à chacun de ces tests permette d'aboutir à un système d'équations présentant une solution unique. Il est également à noter que certains tests faisant intervenir des circuits d'analyse PIC1, PIC2 différents et des liaisons différentes, peuvent être effectués en parallèle, comme les tests n°1 et 4 du tableau 2.

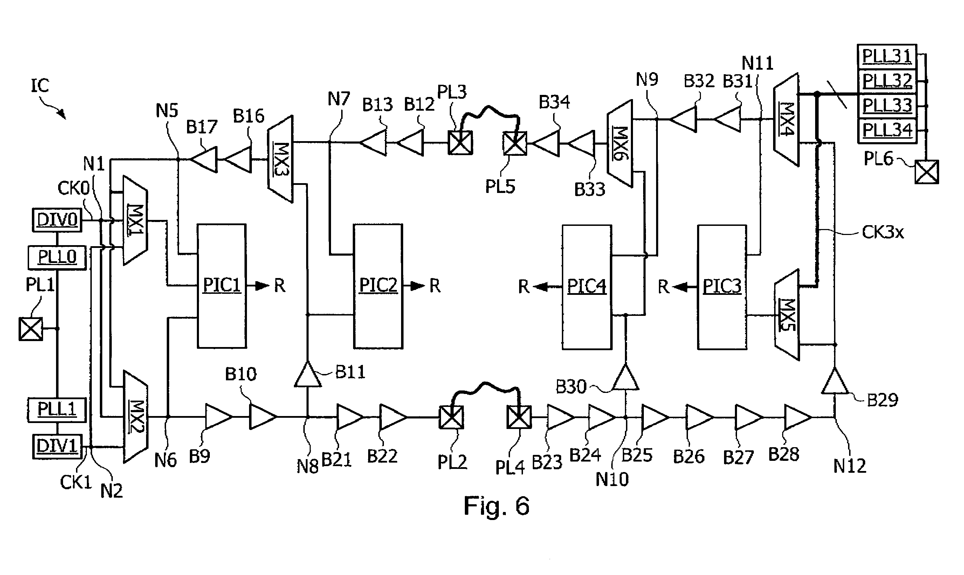

La figure 6 représente le circuit intégré IC comprenant une première partie comprenant les deux circuits d'analyse de l'intégrité de tensions d'alimentation PIC1, PIC2, et une seconde partie comprenant deux autres circuits d'analyse de l'intégrité de tensions d'alimentation PIC3 et PIC4. selon un autre mode de réalisation. Sur la figure 6, la première partie du circuit intégré IC comprend deux plages de connexion PL2, PL3 qui sont connectées à des fins de test par des fils à deux plages de connexion PL4, PL5 de la seconde partie du circuit intégré. La première partie de circuit intégré IC comprend la plage de connexion PL1 connectée aux circuits de génération de signaux d'horloge PLL0 et PLL1, les circuits PLL0 PLL1 étant connectés aux diviseurs de fréquence DIV0, DIV1. La première partie de circuit intégré IC comprend également les multiplexeurs MX1, MX2, MX3. La sortie du multiplexeur MX3 est connectée au noeud N5 uniquement par les portes de transfert B16 et B17, le noeud N5 étant connecté à une entrée des multiplexeurs MX1 et MX2, ainsi qu'à une entrée du circuit PIC2. La sortie du multiplexeur MX2 est connectée à un noeud N6, le noeud N6 étant connecté à une entrée du circuit PIC1 et relié à la plage de connexion PL2 par l'intermédiaire des portes de transfert B9, B10, B21 et B22. La sortie de la porte B10 est connectée à un noeud N8 relié à une entrée du circuit PIC2 par l'intermédiaire de la porte B11. Une entrée du circuit PIC2 est connectée à un noeud N7 connecté à une entrée du multiplexeur MX3, et relié à une plage de connexion PL3 du circuit intégré IC par l'intermédiaire des portes B12 et B13 uniquement.

La seconde partie du circuit intégré IC comprend des multiplexeurs MX4, MX5, MX6 et des circuits de génération de signaux d'horloge PLL31, PLL32, PL33, PLL34 connectés en entrée à une plage de connexion PL6. Chaque sortie des circuits PLL31, PLL32, PLL33, PLL34 est connectée à une entrée respective de chacun des multiplexeurs MX4, MX5. La plage de connexion PL4 est reliée à un noeud N12 en entrée des multiplexeurs MX4 et MX5, par l'intermédiaire de portes de transfert B23, B24, B25, B26, B27, B28, B29. La sortie du multiplexeur MX4 est connectée à un noeud N11 relié à un noeud N9 en entrée du multiplexeur MX6, par l'intermédiaire de portes de transferts B30 et B31. La sortie du multiplexeur MX6 est reliée à la plage de connexion PL5 par l'intermédiaire de portes de transfert B33, B34. Des entrées du circuit PIC3 sont connectées aux sorties des multiplexeurs MX4 et MX5. Le noeud N9 est relié à une entrée du circuit PIC4. La liaison entre les portes B24 et B25 comporte un noeud N10 relié par l'intermédiaire d'une porte de transfert 630, à une entrée du circuit PIC4 et à une entrée du multiplexeur MX6.

Les multiplexeurs MX1 à MX6 et les circuits PIC1 à PIC4 sont commandés par mot de commande émis par un dispositif de test (non représenté) pour sélectionner les signaux à appliquer respectivement à l'entrée Ref et à l'entrée Obs des circuits JEC des circuits PIC1 à PIC4. Dans un mode de réalisation, les circuits d'analyse PIC1-PIC4 sont commandés pour réaliser une série de tests telle que celle résumée dans le tableau 3 suivant :

Tableau 3

| Test | Circuit d'analyse | Ref | Obs | Liaison | Résultat mesuré |
|------|-------------------|-----|-----|---------|-----------------|
| 1 | PIC1 | CK1 | CK0 | | R11=V(CkO)+V(Ck1) |
| 2 | PIC1 | CK1 | CK0 | N6-N8-N5 | R12=V(Ck0)+V(Ck1)+V(N8)+V(N5) |
| 3 | PIC1 | CK1 | CK0 | N8-N8-N10-N7-N5 | R13=V(Ck0)+V(Ck1)+V(N8)+ V(N10) +V(N7)+V(N5) |
| 4 | PIC1 | CK1 | CK0 | N6-N8-N10-N12-N9-N7-N5 | R14=V(Ck0)+V(Ck1)+V(N8)+V(N10)+ V(N12)+V(N9)+V(N7)+V(N5) |
| 5 | PIC1 | CK1 | CK3x | /N11-N9-N7-N5 | R15=V(Ck1)+V(Ck3x)+V(N9)+ V(N7)+V (N5) |
| 6 | PIC2 | CK1 | CK3x | N6-N8/N11-N9-N7 | R16=V(Ck1)+V(Ck3x)+V(N8)+ V(N9)+V (N7) |
| 7 | PIC4 | CK1 | CK3x | N6-N8-N10/ N1-N9 | R17=V(Ck1)+V(Ck3x)+V(N8)+ V(N10) +V(N9) |
| 8 | PIC3 | CK1 | CK3x | N6-N8-N10-N12/ | R18=V(Ck1)+V(Ck3x)+V(N8)+ V(N10) +Y(N12) |
| 9 | PIC3 | CK0 | CK3x | N6-N8-N10-N12/ | R19=V(Ck0)+V(Ck3x)+V(N8)+ V(N10) +V(N12) |

La colonne "Test" du tableau 3 indique un numéro pour chaque test de la série de tests. La colonne "Circuit d'analyse" indique le circuit d'analyse PIC1-PIC4 mis en oeuvre pour réaliser chacun des tests. Les colonnes "Ref" et "Obs" indiquent les signaux d'horloge fournis respectivement aux entrées Ref et Obs du circuit JEC des circuits PIC1, PIC2, PIC3, PIC4 indiqué dans la colonne "Circuit d'analyse". La colonne "Liaison" indique le cas échéant par quelles liaisons ont transité les signaux mentionnés dans les colonnes "Ref" et "Obs", et la colonne "Résultat" indique la valeur obtenue à partir de la mesure fournie par le circuit PIC1-PIC4 indiqué dans la colonne "Circuit d'analyse".

Dans un premier test de la série de tests, les signaux d'horloge CK0 et CK1 en sortie des diviseurs DIVO et DIV1 sont fournis directement par les multiplexeurs MX1 et MX2 respectivement aux entrées Obs et Ref du circuit JEC dans le circuit PIC1. Le résultat obtenu R11 est proportionnel à la somme des variances de gigue V(CKO) et V(CK1) des signaux d'horloge CK0, CK1. Dans un second test, les multiplexeurs MX1 à MX3 sont commandés pour fournir aux entrées Obs et Ref du circuit JEC du circuit PIC1, les signaux d'horloge CK0 et CK1 en sortie des diviseurs DIVO et DIV1, directement ou successivement par l'intermédiaire de la liaison entre les noeuds N6 et N8, et la liaison directe entre les noeuds N8 et N5 (passant par la porte B11). Le résultat obtenu R12 est proportionnel à la somme des variances de gigue V(CK0), V(CK1), et des variances de gigue V(N8), V(N5) introduites par les liaisons N6-N8 et N8-N5. Dans un troisième test, les multiplexeurs MX1 à MX3 et MX6 sont commandés pour fournir aux entrées Obs et Ref du circuit JEC du circuit PIC1, les signaux d'horloge CK0 et CK1 directement et successivement par l'intermédiaire des liaisons entre les noeuds N6 et N8, entre les noeuds N8 et N10, entre les noeuds N10 et N7 (passant par la porte B30), et entre les noeuds N7 et N5. Le résultat obtenu R13 est proportionnel à la somme des variances de gigue V(CK0), V(CK1), V (N8), et des variances de gigue V(N10), V(N7) et V(N5), introduites par la liaison entre les noeuds N8 et N10, par la liaison directe entre les noeuds N10 et N7 (via la porte B30) et par la liaison entre les noeuds N7 et N5. Dans ce test, il est considéré que la variance de gigue introduite par la liaison entre les noeuds N7 et N5 est sensiblement égale à la variance de gigue V(N5) introduite par la liaison directe (passant par la porte B11) entre les noeuds N8 et N5. Dans un quatrième test, les multiplexeurs MX1 à MX3, MX4 et MX6 sont commandés pour fournir aux entrées Obs et Ref du circuit JEC du circuit PIC1, les signaux d'horloge CK0 et CK1 directement et successivement par l'intermédiaire des noeuds N6, N8, N10, N12, N9, N7 et N5. Le résultat obtenu R14 est proportionnel à la somme des variances de gigue V(CK0), V(CK1), V(N8), V(N10), V(N7), V(N5), et des variances de gigue V(N12) et V(N9) introduites par les liaisons entre les noeuds N10 et N12, et entre les noeuds N12 et N9. Dans ce test, il est considéré que la variance de gigue introduite par la liaison entre les noeuds N12 et N9 est sensiblement égale à la variance de gigue de la liaison entre les noeuds N11 et N9. Dans un cinquième test, les multiplexeurs MX2 à MX4 et MX6 sont commandés pour fournir aux entrées Obs et Ref du circuit JEC du circuit PIC1, directement le signal d'horloge CK1, et l'un des signaux d'horloge CK3x successivement par l'intermédiaire des noeuds N11, N9, N7 et N5. Le résultat obtenu R15 est proportionnel à la somme des variances de gigue V(CK1), V(CK3x), V(N5), V(N7) et V(N9). Dans un sixième test, les multiplexeurs MX2, MX4 et MX6 sont commandés pour fournir aux entrées Obs et Ref du circuit JEC du circuit PIC2, le signal d'horloge CK1 par l'intermédiaire des noeuds N6 et N8, et l'un des signaux d'horloge CK3x successivement par l'intermédiaire des noeuds N11, N9 et N7. Le résultat obtenu R16 est proportionnel à la somme des variances de gigue V(CK1), V(CK3x), V(N8), V(N9) et V(N7). Dans un septième test, les multiplexeurs MX2 et MX4 sont commandés pour fournir aux entrées Obs et Ref du circuit JEC du circuit PIC4, le signal d'horloge CK1 successivement par l'intermédiaire des noeuds N6, N8 et N10 et l'un des signaux d'horloge CK3x par l'intermédiaire des noeuds N11 et N9. Le résultat obtenu R17 est proportionnel à la somme des variances de gigue V(CK1), V(CK3x), V(N8), V(N10) et V(N9). Dans un huitième test, les multiplexeurs MX2, MX4 et MX5 sont commandés pour fournir aux entrées Obs et Ref du circuit JEC du circuit PIC3 le signal d'horloge CK1 successivement par l'intermédiaire des noeuds N6, N8, N10 et N12, et directement l'un des signaux d'horloge CK3x. Le résultat obtenu R18 est proportionnel à la somme des variances de gigue V(CK1), V(CK3x), V(N8), V(N10) et V(N12). Enfin, dans un neuvième test, les multiplexeurs MX2, MX4 et MX5 sont commandés pour fournir aux entrées Obs et Ref du circuit JEC du circuit PIC3, le signal d'horloge CK0 successivement par l'intermédiaire des noeuds N6, N8, N10 et N12 et directement l'un des signaux d'horloge CK3x. Le résultat obtenu R19 est proportionnel à la somme des variances de gigue V(CK0), V(CK3x), V(N8), V(N10) et V(N12).

Les neuf tests mentionnés dans le tableau 3 permettent donc d'obtenir un système de neuf équations à neuf inconnues V(CK0), V(CK1), V(CK3x), V(N5), V(N7), V(N8), V(N9), V(N10), V(N12), dont la résolution permet d'obtenir d'une manière indépendante les variances de gigue respectives des signaux CK0, CK1, CK3x, et celles introduites par la liaison entre les noeuds N8 et N10, la liaison entre les noeuds N8 ou N7 et N5, la liaison entre les noeuds N8 et N10, la liaison entre les noeuds N10 ou N9 et N7, la liaison entre les noeuds N10 et N12, et la liaison entre les noeuds N12 ou N11 et N9, comme suit :

$$V(CK0) = (R11 + R19 - R18)/2 \qquad (10)$$

$$V(CK1) = (R11 + R18 - R19)/2 \qquad (11)$$

$$V(CK3x) = (R15 + R19 - R14)/2 \qquad (12)$$

$$V(N5) = (R12 + R15 - R11 - R16)/2 \qquad (13)$$

$$V(N7) = (R13 + R16 - R12 - R17)/2 \qquad (14)$$

$$V(N8) = (R12 + R16 - R11 - R15)/2 \qquad (15)$$

$$V(N9) = (R14 + R17 - R13 - R18)/2 \qquad (16)$$

$$V(N10) = (R13 + R17 - R12 - R16)/2 \qquad (17)$$

$$V(N12) = (R14 + R18 - R13 - R17)/2 \qquad (18)$$

Etant donné que chaque test fournit au minimum la somme de deux variances, le nombre de noeuds de prélèvement d'un signal dont la variance est à déterminer est supérieur ou égal à trois, et le nombre de tests d'une série est également supérieur ou égal à trois. Il peut s'agir de trois noeuds par lesquels transite un même signal ou transitent deux ou trois signaux distincts.

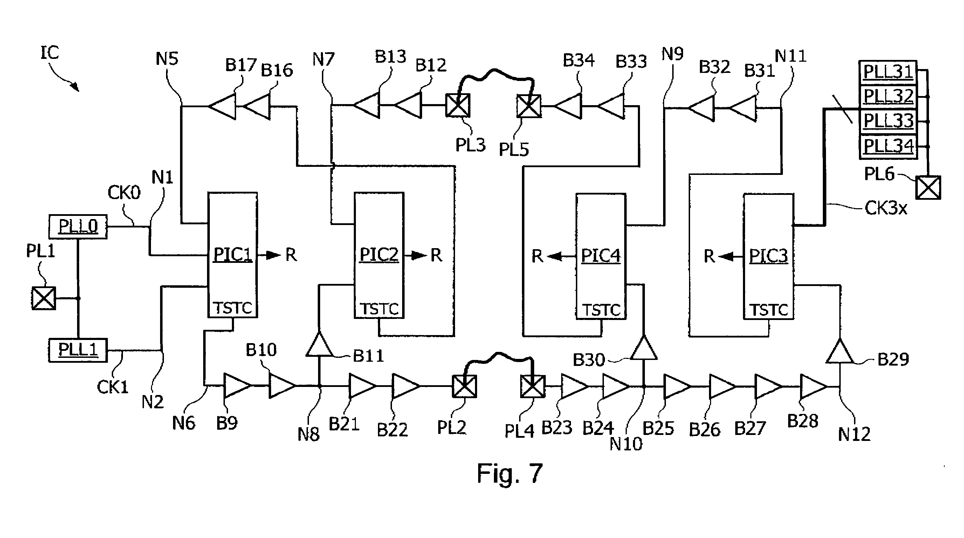

Si l'on prévoit dans le circuit PIC, comme représenté sur la figure 2, une sortie supplémentaire d'interconnexion TSTC reliée à la sortie de l'un des diviseurs DIVA, DIVB, le circuit de test représenté sur la figure 6 peut être simplifié comme représenté sur la figure 7. Sur la figure 7, les diviseurs DIV1, DIV2 sont supprimés du circuit de test car ils peuvent être remplacés par les diviseurs DIVA, DIVB des circuits PIC1 à PIC4. De même, les multiplexeurs MX1 à MX6 sont supprimés du circuit de test car ils peuvent être remplacés par les multiplexeurs MXA, MXB des circuits PIC1 à PIC4. A cet effet, les sorties des circuits d'horloge PLL0 et PLL1 sont connectées à des entrées du circuit PIC1. Le noeud N6 est connecté à la sortie TSTC du circuit PIC1. La sortie de la porte B17 est connecté à une entrée du circuit PIC1. La sortie de la porte B11 et le noeud N7 sont connectés à des entrées du circuit PIC2. La sortie TSTC du circuit PIC2 est connectée à l'entrée de la porte 816. La sortie de la porte B30 et le noeud N9 sont connectés à des entrées du circuit PIC4. La sortie TSTC du circuit PIC4 est connectée à l'entrée de la porte B33. La sortie de la porte B29 et les sorties des circuits d'horloge PLL31-PLL34 sont connectés à des entrées du circuit PIC3. La sortie TSTC du circuit PIC3 est connectée au noeud N11 à l'entrée de la porte B31. Les tests résumés dans le tableau 1 peuvent être réalisés en commandant d'une manière adéquate les circuits PIC1 à PIC4.

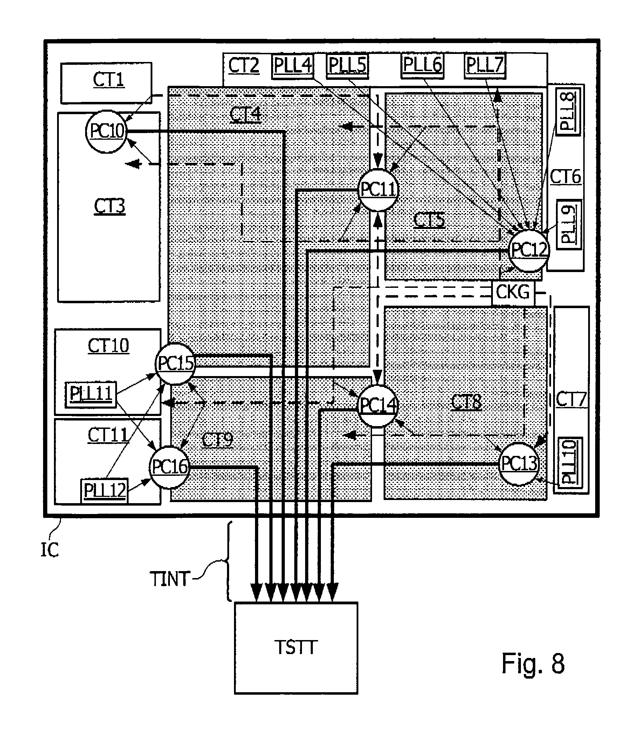

La figure 8 représente le circuit intégré IC comprenant plusieurs blocs de circuit CT1 à CT91, ainsi qu'un circuit principal de génération de signaux d'horloge CKG. Le bloc CT2 comprend quatre circuits de génération de signaux d'horloge PLL4 à PLL7. Le bloc CT6 comprend deux circuits de génération de signaux d'horloge PLL8. PLL9. Les blocs CT7, CT10 et CT11 comprennent chacun un circuit de génération de signaux d'horloge PLL10, PLL11, PLL12.

Selon un mode de réalisation, le circuit intégré IC comprend également plusieurs circuits d'analyse de l'intégrité de tensions d'alimentation PC10 à PC16, analogues au circuit PIC représenté sur la figure 2. Les circuits PC10-PC16 peuvent être disposés entre les blocs de circuits CT1 à CT11, pour analyser l'intégrité des tensions d'alimentation fournies à ces blocs CT1 à CT11. Ainsi, le circuit PC10 est disposé entre les blocs CT1 et CT2, et reçoit un signal d'horloge du bloc CT1 et un signal d'horloge du bloc CT3, issu du circuit CKG. Le circuit PC11 est disposé entre les blocs CT4 et CT5, et reçoit des signaux d'horloge générés par les blocs CT1 et le circuit CKG, et des signaux d'horloge des circuits CT5 et CT3, issus du circuit CKG. Le circuit PC12 est disposé entre les blocs CT5 et CT6 et à proximité du circuit CKG, et reçoit des signaux d'horloge générés par les circuits PLL4 à PLL9, ainsi qu'un signal d'horloge issu du circuit CKG pour les circuits CT2, CT3 et CT4. Le circuit PC13 est disposé entre les blocs CT7 et CT8, et reçoit des signaux d'horloge générés par les circuits CKG et PLL10, et un signal d'horloge du circuit CT9 issu du circuit CKG. Le circuit PC14 est disposé entre les blocs CT8 et CT9, et reçoit des signaux d'horloge générés par le circuit CKG, et des signaux d'horloge des circuits CT9 et CT10 issu du circuit CKG. Le circuit PC15 est disposé entre les blocs CT4, CT9 et CT10. Le circuit PC16 est disposé entre les blocs CT9 et CT11. Les circuits PC15 et PC16 reçoivent des signaux d'horloge générés par les circuits PLL11 et PLL12, et un signal d'horloge du circuit CT9, issu du circuit CKG. Les circuits PC10-PC16 sont connectés à un dispositif de test TSTT par l'intermédiaire d'une interface de connexion TINT, pour réaliser des mesures telles que celles décrites dans les tableaux 1 à 3. Le dispositif TSTT est configuré pour commander des multiplexeurs afin de sélectionner les signaux fournis aux entrées Ref et Obs des circuits de mesure de gigue JEC des circuits PC10 à PC16, à chaque test d'un ensemble de tests, pour recueillir les valeurs mesurées, pour en déduire de ces valeurs mesurées les variances de gigue des signaux fournis aux circuits JEC, et pour déterminer à partir de ces variances de gigue des variances de gigue de signaux en sortie de circuits de génération de signaux d'horloge et de liaisons dans le circuit intégré IC.

Il apparaîtra clairement à l'homme de l'art que la présente invention est susceptible de diverses variantes de réalisation et diverses applications. En particulier, l'invention n'est pas limitée au procédé de mesure de gigue décrit en référence à la figure 3. D'autres procédés de mesure de gigue comme celui décrit dans la demande de brevet US2007/002994 peuvent être mis en oeuvre dans le cadre de la présente invention, conduisant à d'autres relations entre la variance ou l'écart type de gigue et les mesures de gigue obtenues. Il en résulte que l'équation (1) n'est pas nécessairement utilisée, car elle dépend de la mesure de gigue mise en oeuvre.

**Revendications**

1. Procédé de test d'un circuit intégré,
   **caractérisé en ce qu'**il comprend des étapes de réalisation d'une série d'au moins trois tests, chacun des tests comprenant des étapes consistant à:

   sélectionner deux noeuds parmi au moins trois noeuds de prélèvement (N1-N12) d'un signal d'horloge, dans un circuit intégré (IC),
   prélever deux signaux d'horloge (CKO, CK1, CK2, CK3, CK3x) aux deux noeuds de prélèvement sélectionnés pendant une durée de test,
   détecter et compter des événements apparaissant dans un signal de gigue entre les deux signaux d'horloge prélevés, pendant la durée de test, et
   déterminer à partir de nombres d'événements comptés (NA, NB, NTc) un résultat de test proportionnel à une somme de variances de gigue des deux signaux d'horloge prélevés,
   le procédé comprenant une étape de détermination de la variance de gigue de chacun des signaux d'horloge prélevés durant la série de tests, le nombre de tests de la série de tests et les signaux prélevés à chacun des tests de la série de test étant choisis de manière à pouvoir déterminer par un calcul matriciel la variance de gigue de chacun des signaux d'horloge prélevés.

2. Procédé selon la revendication 1, dans lequel la variance de gigue d'un signal d'horloge (CK0, CK1, CK2, CK3, CK3x) prélevé en un noeud (N1-N12) à distance d'une sortie d'un circuit de génération (PLLO-PLL12) du signal d'horloge, est égale à une variance de gigue du signal d'horloge en sortie du circuit de génération du signal d'horloge prélevé, additionnée d'une variance de gigue introduite par une liaison transmettant le signal d'horloge entre la sortie du circuit de génération et le noeud de prélèvement du signal d'horloge, le procédé comprenant une étape de détermination de la variance de gigue du signal d'horloge en sortie du circuit de génération du signal d'horloge, et de la variance de gigue introduite par la liaison entre la sortie du circuit de génération du signal d'horloge et le noeud de prélèvement du signal d'horloge prélevé, le nombre de tests de la série de tests et les signaux prélevés à chacun des tests de la série de tests étant choisis de manière à pouvoir déterminer par un calcul matriciel la variance de gigue de chacun des signaux d'horloge en sortie de leur circuit de génération et la variance de gigue de chacune des liaisons entre un point de prélèvement sélectionné d'un signal d'horloge et la sortie du circuit de génération du signal d'horloge.

3. Procédé selon la revendication 1 ou 2, comprenant une étape de prélèvement d'un échantillon d'un premier des deux signaux prélevés (Obs) à chaque période d'un second des deux signaux prélevés (Ref), et de mémorisation des échantillons prélevés, les événements comptés comprenant des événements d'apparition d'un motif particulier ou de coïncidence avec un masque particulier, dans les échantillons mémorisés, et des événements de coïncidence de phase entre les deux signaux prélevés.

4. Procédé selon la revendication 3, dans lequel le résultat de chacun des tests de la série de test est obtenu par la formule suivante:

$$R = \left( \frac{NA + NB}{NTc} \cdot |Tobs - Tref| \right)^2$$

dans laquelle R est le résultat du test, NA et NB sont les valeurs de deux compteurs (PCN1, PCN2) d'apparition d'un motif particulier dans les échantillons mémorisés ou de coïncidence des échantillons mémorisés avec un masque particulier, NTc est la valeur d'un compteur incrémenté à chaque fois que les deux signaux prélevés sont détectés en phase, et Tobs et Tref sont les périodes des deux signaux prélevés (Obs, Ref).

5. Procédé selon l'une des revendications 1 à 4, comprenant une étape de prévision dans le circuit intégré (IC) d'au moins un circuit d'analyse d'intégrité de tension d'alimentation (PIC, PICI-PIC6, PC10-PC16) comprenant un circuit de mesure de gigue (JEC1-JEC4) et des multiplexeurs (MX1-MX7, MX11-MX17) permettant de sélectionner des signaux d'horloge à prélever (CKO, CK1, CK2, CK3, CK3x) et des noeuds de prélèvement (N1-N8) des signaux d'horloge.

6. Procédé selon l'une des revendications 1 à 5, comprenant une étape de prévision dans le circuit intégré (IC) de plusieurs circuits d'analyse d'intégrité de tension d'alimentation (PIC, PIC1-PIC6, PC10-PC16) comprenant chacun un circuit de mesure de gigue (JEC1-JEC4) et des multiplexeurs (MX1-MX7, MX11-MX17) permettant de sélectionner des signaux d'horloge à prélever (CKO, CK1, CK2, CK3, CK3x) et des noeuds de prélèvement (N1-N8) des signaux d'horloge, les circuits d'analyse d'intégrité de tension d'alimentation étant localisés sur le circuit intégré entre des blocs (CT1-CT11) du circuit intégré ou à proximité de sources de signaux d'horloge (PLL10-PLL12, CKG).

7. Procédé selon l'une des revendications 1 à 6, comprenant des étapes de réalisation de la série de tests dans différentes conditions de fonctionnement du circuit intégré (IC), de comparaison des variances de gigue obtenues à chaque série de test, et de déduction d'informations relatives à l'intégrité de tensions d'alimentation.

8. Système test d'un circuit intégré (IC),
**caractérisé en ce qu'**il est configuré pour mettre en oeuvre le procédé selon l'une des revendications 1 à 7.

9. Circuit intégré comprenant au moins un circuit de génération d'un signal d'horloge (PLLO-PLL10) et des noeuds de prélèvement (N1-N12) de signal d'horloge (CKO-CK3),
**caractérisé en ce qu'**il comprend un circuit d'analyse d'intégrité de tension d'alimentation (PIC, PIC1-PIC4, PC10-PC16) configuré pour :

recevoir d'un dispositif de test (TSTT) des signaux de sélection de deux noeuds de prélèvement de signaux d'horloge, parmi au moins trois noeuds de prélèvement,

prélever deux signaux d'horloge (CKO, CK1, CK2, CK3, CK3x) aux deux noeuds de prélèvement sélectionnés pendant une durée de test,

détecter et compter des événements apparaissant dans un signal de gigue entre les deux signaux d'horloge prélevés, pendant la durée de test, et

fournir au dispositif de test les nombres d'événements comptés (NA, NB, NTc).

**10.** Circuit intégré selon la revendication 9, dans lequel le circuit d'analyse d'intégrité de tension d'alimentation (PIC, PIC1-PIC4, PC10-PC16) comprend un circuit de mesure de gigue (JEC1-JEC4) et des multiplexeurs (MX1-MX7, MX11-MX17) permettant de sélectionner des signaux d'horloge à prélever (CKO, CK1, CK2, CK3, CK3x) et des noeuds de prélèvement (N1-N8) des signaux d'horloge.

**11.** Circuit intégré selon la revendication 9 ou 10, comprenant plusieurs circuits d'analyse d'intégrité de tension d'alimentation (PIC, PIC1-PIC6, PG10-PC16) comportant chacun un circuit de mesure de gigue (JEC1-JEC4) et des multiplexeurs (MX1-MX7, MX11-MX17) permettant de sélectionner des signaux d'horloge à prélever (CK0, CK1, CK2, CK3, CK3x) et des noeuds de prélèvement (N1-N8) des signaux d'horloge, les circuits d'analyse d'intégrité de tension d'alimentation étant localisés sur le circuit intégré entre des blocs (CT1-CT11) du circuit intégré ou à proximité de sources de signaux d'horloge (PLL10-PLL12, CKG).

**12.** Dispositif de test comprenant une interface de connexion pour se connecter à un circuit intégré (IC), et des moyens pour envoyer et recevoir des signaux par l'interface de connexion,

**caractérisé en ce qu'**il est configuré pour réaliser une série d'au moins trois tests, chacun des tests comprenant des étapes consistant à :

commander la sélection par le circuit intégré (IC) connecté à l'interface de connexion, de deux noeuds parmi au moins trois noeuds de prélèvement (N1-N12) d'un signal d'horloge, le prélèvement par le circuit intégré de deux signaux d'horloge (CKO, CK1, CK2, CK3, CK3x) aux deux noeuds de prélèvement sélectionnés, pendant une durée de test, et la détection et le comptage d'événements apparaissant dans un signal de gigue entre les deux signaux d'horloge prélevés, pendant la durée de test, et

acquérir et déterminer à partir des nombres d'événements comptés (NA, NB, NTc) un résultat de test proportionnel à une somme de variances de gigue des deux signaux d'horloge prélevés,

le dispositif de test étant configuré pour déterminer la variance de gigue de chacun des signaux d'horloge prélevés durant la série de tests, le nombre de tests de la série de tests et les signaux prélevés à chacun des tests de la série de test étant choisis de manière à pouvoir déterminer par un calcul matriciel la variance de gigue de chacun des signaux d'horloge prélevés.

**13.** Dispositif de test selon la revendication 12; dans lequel la variance de gigue d'un signal d'horloge (CKO, CK1, CK2, CK3, CK3x) prélevé en un noeud (N1-N12) à distance d'une sortie d'un circuit de génération (PLLO-PLL12) du signal d'horloge, est égale à une variance de gigue du signal d'horloge en sortie du circuit de génération du signal d'horloge prélevé, additionnée d'une variance de gigue introduite par une liaison transmettant le signal d'horloge entre la sortie du circuit de génération et le noeud de prélèvement du signal d'horloge, le dispositif de test étant configuré pour déterminer la variance de gigue du signal d'horloge en sortie du circuit de génération du signal d'horloge, et la variance de gigue introduite par la liaison entre la sortie du circuit de génération du signal d'horloge et le noeud de prélèvement du signal d'horloge prélevé, le nombre de tests de la série de tests et les signaux prélevés à chacun des tests de la série de tests étant choisis de manière à pouvoir déterminer par un calcul matriciel la variance de gigue de chacun des signaux d'horloge en sortie de leur circuit de génération et la variance de gigue de chacune des liaisons entre un point de prélèvement sélectionné d'un signal d'horloge et la sortie du circuit de génération du signal d'horloge.

**14.** Dispositif de test selon l'une des revendications 12 et 13, configuré calculer un résultat de chacun des tests de la série de test par la formule suivante:

$$R = \left( \frac{NA + NB}{NTc} \cdot |Tobs - Tref| \right)^2$$

dans laquelle R est le résultat du test, NA et NB sont les valeurs de deux compteurs (PCN1, PCN2) d'apparition d'un motif particulier dans les échantillons mémorisés ou de coïncidence des échantillons mémorisés avec un masque particulier, NTc est la valeur d'un compteur incrémenté à chaque fois que les deux signaux prélevés sont détectés en phase, et Tobs et Tref sont les périodes des deux signaux prélevés (Obs, Ref).

**15.** Dispositif de test selon l'une des revendications 12 à 14, configuré pour réaliser la série de tests dans différentes conditions de fonctionnement du circuit Intégré (IC), et comparer les variances de gigue obtenues à chaque série de tests.

Fig. 1

Fig. 2

Fig. 3

Fig. 4

Fig. 5

Fig. 6

Fig. 7

EP 2 327 992 A1

Fig. 8

**Europäisches Patentamt**
**European Patent Office**
**Office européen des brevets**

## RAPPORT DE RECHERCHE EUROPEENNE

Numéro de la demande

EP 10 01 4405

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 1 841 066 A1 (ST MICROELECTRONICS SA [FR]) 3 octobre 2007 (2007-10-03) * alinéa [0028] - alinéa [0050] * ----- | 1-15 | INV. G01R31/317 G01R29/26 |
| A | US 2003/202573 A1 (YAMAGUCHI TAKAHIRO [JP] ET AL) 30 octobre 2003 (2003-10-30) * alinéa [0015] - alinéa [0036] * ----- | 1-15 | |
| A,D | US 2007/002994 A1 (KANTER OFIR [IL] ET AL) 4 janvier 2007 (2007-01-04) * alinéa [0008] - alinéa [0024] * ----- | 1-15 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| Munich | 27 janvier 2011 | Meggyesi, Zoltán |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 01 4405

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-01-2011

| Document brevet cité au rapport de recherche | | Date de publication | Membre(s) de la famille de brevet(s) | | Date de publication |
|---|---|---|---|---|---|
| EP 1841066 | A1 | 03-10-2007 | FR<br>US | 2899404 A1<br>2007229326 A1 | 05-10-2007<br>04-10-2007 |
| US 2003202573 | A1 | 30-10-2003 | DE<br>WO<br>JP | 10392587 T5<br>03093846 A1<br>4216249 B2 | 07-07-2005<br>13-11-2003<br>28-01-2009 |
| US 2007002994 | A1 | 04-01-2007 | WO | 2007005878 A1 | 11-01-2007 |

EPO FORM P0460

Pour tout renseignement concernant cette annexe : voir Journal Officiel de l'Office européen des brevets, No.12/82

**EP 2 327 992 A1**

**RÉFÉRENCES CITÉES DANS LA DESCRIPTION**

**Documents brevets cités dans la description**

- US 2007002994 A